# EUROPÄISCHE PATENTSCHRIFT

(11) **EP 0 355 377 B1**
(45) Veröffentlichungstag und Bekanntmachung des Hinweises auf die Patenterteilung: **26.01.1994**
(21) Anmeldenummer: 89112777.1
(22) Anmeldetag: 12.07.1989
(51) Int. Cl.: H05K 13/08, G06F 15/70, G01B 11/24

(54) **Verfahren zur optischen Prüfung von Flachbaugruppen**
Method for testing optically flat electronic component assemblies
Méthode d'essai optique d'assemblages plats de composants électroniques

(30) Priorität: 05.08.1988 DE 3826735
(43) Veröffentlichungstag der Anmeldung: 28.02.1990
(73) Patentinhaber: SIEMENS AKTIENGESELLSCHAFT, 80333 München (DE)
(72) Erfinder: Doemens, Günter, Dr., D-8150 Holzkirchen (DE); Mengel, Peter, Dr., D-8031 Eichenau (DE); Thum-Rung, Charlotte, Dr., D-8028 Taufkirchen (DE)

(56) Entgegenhaltungen:
- EP-A- 0 157 299
- EP-A- 0 183 565
- EP-A- 0 228 963
- WO-A-87/03719
- US-A- 4 677 302
- IBM TECHNICAL DISCLOSURE BULLETIN, Band 29, Nr. 5, Oktober 1986, Seiten 2216-2223, New York, US; "Component placement verification through height discontinuities"
- PATENT ABSTRACTS OF JAPAN, Band 10, Nr. 308 (P-508)[2364], 21. Oktober 1986 & JP-A-61-122 509
- PATENT ABSTRACTS OF JAPAN, Band 10, Nr. 183 (P-472)[2239], 26. Juni 1986 & JP-A-61-31 906
- PATENT ABSTRACTS OF JAPAN, Band 11, Nr. 29 (P-540)[2476], 28. Januar 1987 & JP-A-61-200 411
- PATENT ABSTRACTS OF JAPAN, Band 11, Nr. 126 (P-569)[2573], 21. April 1987 & JP-A-61-269 009

## Beschreibung

Die Erfindung betrifft ein Verfahren zur optischen Prüfung von Flachbaugruppen, wobei eine Bestückungsanalyse einer Leiterplatte mit oberflächenmontierbaren oder bedrahteten Bauelementen oder mit gemischter Bestückung vorgenommen wird.

Da beim Montagevorgang von Bauelementen auf Leiterplatten Fehlbestückungen nicht auszuschließen sind, muß eine Kontrolle auf Vollständigkeit und richtige Lageorientierung der Bauelemente erfolgen. Derzeit auf dem Markt erhältliche Geräte zur Durchführung derartiger Kontrollen arbeiten mit einer zweidimensionalen Graubildverarbeitung. Die Bildauswertung zur Fehlererkennung durch den Vergleich mit einer Masterplatte wird dabei nach Grauwertunterschieden an den zu beurteilenden Prüfstellen durchgeführt. Voraussetzung hierzu ist eine homogene Beleuchtung der Flachbaugruppe, sowie ausreichende Kontrastunterschiede der Bauelemente untereinander und zur Leiterplatte. Räumliche Lagerorientierungen der Bauelemente können mit dieser zweidimensionalen Methode jedoch prinzipiell nicht bestimmt werden.

Ein weiterer Entwicklungsschritt zur Erkennung dreidimensionaler Strukturen wird durch den Einsatz von 3D-Sensoren vollzogen, die bereits bekannt sind. Derartige dreidimensional aufnehmende Sensoren erfassen Oberflächenkoordinaten (X,Y,Z) eines Objektes nach dem Prinzip der Lasertriangulation oder Laserphasenmessung. Die zu verarbeitende Bildinformation liegt in der Regel in Form von Höhenrasterlinien vor. Dabei läßt sich an jedem Meßort (X,Y) über die Triangulation die Höhe des Meßortes, also die Z-Komponente der Oberfläche des Meßobjektes, angeben. Die daraus entstehenden Höhenrasterbilder können von beiden Seiten der Leiterplatte aufgenommen werden.

Ein Anwendungsverfahren der Lasertriangulation ist in der Patentschrift US 4 677 302 wiedergegeben. Die hierin angegebenen Auswerteverfahren mittels Integration der Lichtintensität entlang von Konturen führen jedoch nur zu einer einfachen Aussage über die mittlere Höhenlage des Meßobjektes. Man erhält hier keine direkt ortsaufgelöste Höhenrasterlinie, sondern lediglich eine über eine bestimmte Länge gemittelte.

Ein Nachteil, der beiden genannten Verfahren gemeinsam anhaftet, ist der erhebliche Rechenaufwand. Bei der Graubildverarbeitung steht in der Regel nur ein einziges zweidimensionales Bild zur Verfügung, aus dem eine räumliche Struktur interpretiert werden muß. Das Erkennen von diffizilen Strukturen erfordert daher eine umfangreiche Wissensbasis zur Lösung des Problemes. Die Verarbeitung von mehreren Grauwertbildern eines Objektes aus verschiedenen Blickrichtungen kann dreidimensionale Koordinaten erkennen. Hierzu sind jedoch auf den verschiedenen Bildern korrespondierende Punkte nötig, was wiederum bei komplexen Objekten sehr aufwendig ist.
Der Einsatz von 3D-Sensoren bei gleichzeitiger Erstellung von Höhenrasterlinien ergibt zwar eine verbesserte räumliche Erkennung von Objekten, ist jedoch durch das Auswerteverfahren entsprechend der Patentschrift US 4 677 302 mittels Integration der Lichtintensität immer noch mit hohen Rechenaufwand verbunden. Zudem werden nur mittlere Höhenlagen der Bauelemente erkannt.

In der Veröffentlichung IBM Technical Disclosure Bulletin, Bd. 29, Nr. 5, Oktober 1986, S. 2217-2223 wird ein computerunterstütztes Meßverfahren vorgestellt, mit dem die Anwesenheit, die Position und die Orientierung von elektronischen Komponenten auf Leiterplatten feststellbar ist. Dabei wird die bestückte Leiterplatte in einem System mit einem Laser gescannt. Dies betrifft sowohl die Oberfläche der Bauelemente, als auch mehrere Stellen der Leiterplatte in der Nähe der Bauelemente.

Der Erfindung liegt die Aufgabe zugrunde, eine Bestückungsanalyse an Flachbaugruppen anhand von globalen Merkmalen der Bauelemente vorzunehmen, die eine geringe Störanfälligkeit und eine Datenreduzierung beinhalten.

Diese Aufgabe wird durch ein optisches Verfahren gelöst, bei dem
- mittels eines oder mehrerer 3D-Sensoren und durch Abtasten mittels eines Laser-Scanners die dreidimensionalen Oberflächenkoordinaten (X,Y,Z) der Flachbaugruppe ermittelt werden,
- die globale Erkennung einzelner Bauelemente (3) einer Flachbaugruppe (6) anhand der Bestimmung geometrischer Kennwerte, wie Gesamtvolumen (V), projizierte Fläche (F) und maximale Höhe (H-MAX) des Bauelementes (3) durchgeführt wird,
- eine Bestückungsanalyse anhand eines Soll/Ist-Wertvergleiches zwischen den geometrischen Kennwerten einer der Flachbaugruppe entsprechenden Sollstruktur und denen der Flachbaugruppe (6) vorgenommen wird, und
- die Lageorientierung der einzelnen Bauelemente (3) auf der Flachbaugruppe (6) durch Bestimmung ihrer maximalen Länge (L-MAX) und ihrer maximalen Breite (B-MAX) ermittelt wird.

Der Erfindung liegt die Erkenntnis zugrunde, daß durch globale Merkmale von einem Bauelement, d.h. umfassende und auf das ganze bezogene Kennzeichen, Fehlmessungen an einzelnen Orten der Oberfläche durch die Vielzahl von aufgenommenen Oberflächenkoordinaten unterdrückt werden. Durch die Bestimmung der geometrischen Kennwerte, wie Gesamtvolumen (V), projizierte Fläche (F) und maximale Höhe (H-MAX) eines Bauelementes aus den dreidimensionalen Oberflächenkoordinaten wird die bereitzuhaltende Datenmenge auf ein Minium reduziert, indem die aufgenommenen dreidimensionalen Oberflächenkoordinaten gelöscht werden können. Der Soll/Ist-Wertvergleich zwischen einer Flachbaugruppe und der entsprechenden Sollstruktur wird jeweils anhand dieser geometrischen Kennwerte durchgeführt. Zur Bestimmung der Bauelemente kommt die Lageorientierung der einzelnen Bauelemente auf der Flachbaugruppe hinzu. Dies geschieht durch die Bestimmung ihrer maximalen Länge und ihrer maximalen Breite. Unter Lageorientierung ist in diesem Fall die richtige Ausrichtung in der X/Y-Richtung zu verstehen.

Zur Durchführung des Soll/Ist-Wertvergleiches ist es vorteilhaft, die geometrischen Kennwerte der Istaufnahme oder der Sollstruktur mit vorgegebenen Toleranzgrenzen zu versehen. Hierdurch werden restliche Ungenauigkeiten, die trotz des äußerst präzisen ortsaufgelöst vorliegenden Höhenrasterprofiles auftauchen können, eliminiert.

Ein weiterer Gesichtspunkt der Erfindung betrifft die Neigung eines Bauelementes relativ zur Flachbaugruppe, die durch die Aufnahme eines Höhenhistogrammes ermittelt wird. In einem Höhenhistogramm sind die Anzahl der Punkte gleicher Höhe eines Bauelementes über der Höhe aufgetragen. Ein Beispiel für eine Verkippung ist eine Drehung aus der X/Y-Ebene heraus.

Zur genaueren Kontrolle der Oberfläche eines Bauelementes wird in vorteilhafter Weise die projizierte Fläche in verschiedenen Höhen des Bauelementes aufgenommen.

Besonders vorteilhaft ist die Anwendung einer Nettohöhenkontrolle, die als Untergrundkorrektur Signalverfälschungen bei der Durchbiegung von Leiterplatten oder bei teilweise transparentem Leiterplattenmaterial ausgleicht.

Zur weiteren Datenreduzierung ist vorgesehen, Prüffenster, die an den zu prüfenden Bauelementen orientiert sind, einzurichten, wodurch nicht besetzte Flächen einer Leiterplatte nicht aufgenommen werden müssen.

Im folgenden wird anhand schematischer Zeichnungen ein Ausführungsbeispiel widergegeben.

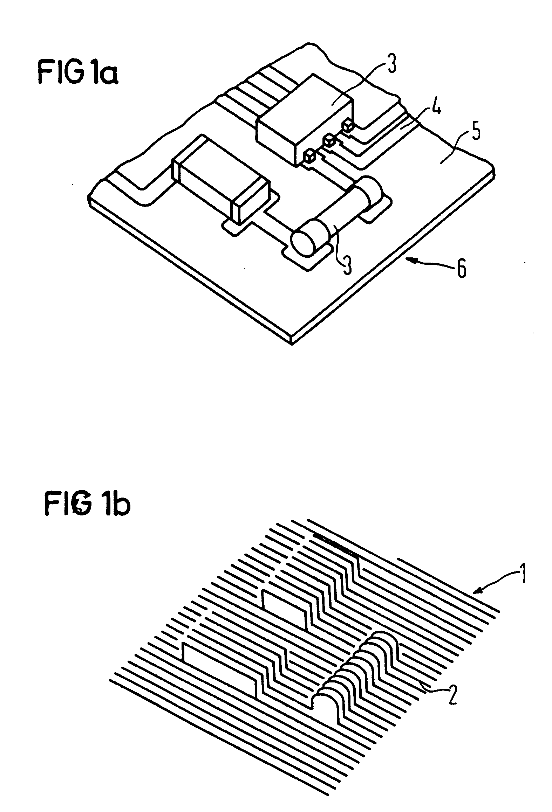

Die Fig. 1 a zeigt den Ausschnitt aus einer Flachbaugruppe 6 bestehend aus Leiterplatte 5, Bauelementen 3 und Leiterbahnen 4.

Die Fig. 1 b zeigt ein Höhenrasterprofil 1 mit Höhenrasterlinien 2, das der Flachbaugruppe 6 in der Fig. 1 a entspricht.

Die Fig. 2 zeigt verschiedene Objektformen, für die ein Höhenrasterprofil 1 mit Höhenrasterlinien 2 dargestellt ist.

Die Fig. 3 zeigt drei verschiedene Höhenhistogramme für einen zylindrischen Körper.
a) die Zylinderachse steht senkrecht auf der X/Y-Ebene
b) die Zylinderachse beschreibt mit einer Flächennormalen auf der X/Y-Ebene einen Winkel = 45°
c) die Zylinderachse liegt parallel zur X/Y-Ebene.

Die Fig. 4 zeigt drei verschiedene Höhenrasterprofile 1 mit jeweils zugehörigem Höhenhistogramm.
a) Höhenrasterprofil 1 für eine Lötstelle mit zu wenig Lotmaterial
b) Höhenrasterprofil 1 für eine gute Lötstelle
c) Höhenrasterprofil für eine Lötstelle mit zuviel Lotmaterial.

In der Fig. 1a ist ein Ausschnitt aus einer zu prüfenden Flachbaugruppe 6 dargestellt, wobei auf einer Leiterplatte 5 Leiterbahnen 4 und Bauelemente 3 plaziert sind. Diese Bauelemente können zum Typ der oberflächenmontierbaren oder zum Typ der bedrahteten Bauelemente zählen. Die Flachbaugruppe kann grundsätzlich von beiden Seiten mittels des erfindungsgemäßen Verfahrens geprüft werden, so daß sowohl beidseitig montierte Bauelemente, als auch zugehörige Lötstellen kontrollierbar sind.

In der Fig. 1b ist ein Höhenrasterprofil dargestellt, das dem Aufbau des Ausschnittes aus einer Flachbaugruppe 6 wie in der Fig. 1 a dargestellt, entspricht. Dieses Höhenrasterprofil 1 ist aus einer Vielzahl von Höhenrasterlinien aufgebaut. Es sind deutlich die zwei quaderförmigen Bauelemente 3 und ein zylinderförmiges Bauelement 3 zu erkennen. Da die Abtastung und Aufnahme der Höhenkoordinaten annähernd senkrecht von oben geschieht, ist im Falle des zylindrischen liegenden Bauelementes 3 die Oberfläche der unteren Hälfte nicht direkt darstellbar. Die Darstellung in Form von Höhenrasterlinien 2 ist nicht zwingend notwendig, dient jedoch der visuellen Verdeutlichung des Gesamtbildes, das aus den dreidimensionalen Oberflächenkoordinaten X, Y, Z besteht, durch die ein digital aufgenommenes und ortsaufgelöstes dreidimensionales Raster-Bild der Flachbaugruppe 6 vorliegt.

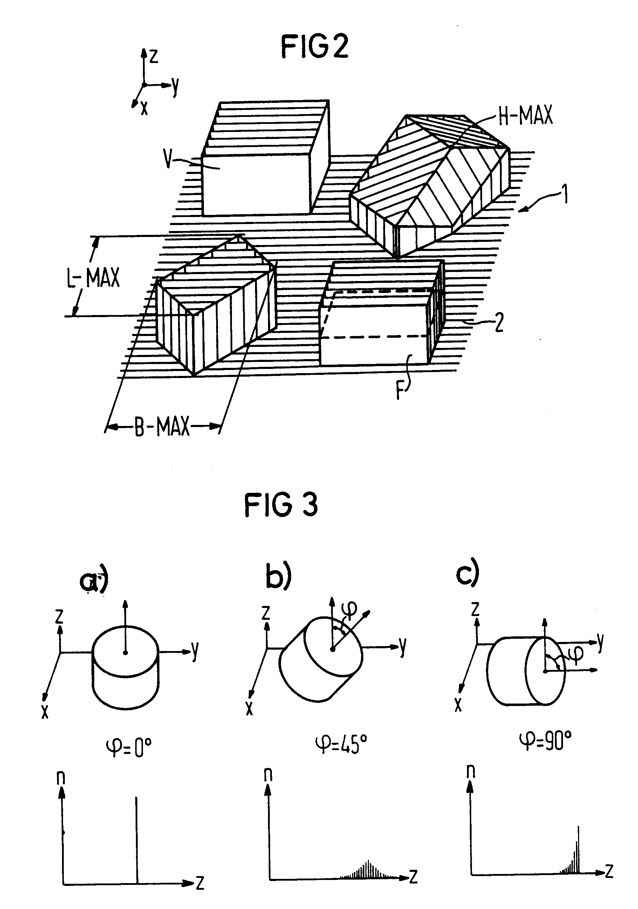

Die Fig. 2 zeigt beispielhaft vier verschiedene Körper mit dem Gesamtvolumen V, der maximalen Höhe H-MAX, der maximalen Länge L-MAX, der maximalen Breite B-MAX und der projizierten Fläche F. Von diesem Ausschnitt einer Flachbaugruppe ist wiederum ein Höhenrasterprofil 1 angefertigt worden, das aus einer Vielzahl von Höhenrasterlinien 2 besteht. Während des Verfahrens zur Prüfung von Flachbaugruppen wird die Analyse dieses Ausschnittes durch grobes Feststellen der Position eines Bauelementes in einem Prüffenster, durch anschließende Aufnahme der dreidimensionalen Oberflächenkoordinaten X, Y, Z und durch Bestimmung der geometrischen Kennwerte wie Gesamtvolumen V, maximale Höhe H-MAX und projizierte Fläche F durchgeführt. Diese drei geometrischen Kennwerte sind für das Meßobjekt lage- und drehinvariant. Somit sind Position und Typ des Bauelementes bestimmt. Zur Verfeinerung der Bestückungsanalyse werden die geometrischen Kennwerte maximale Länge L-MAX und maximale Breite B-MAX ausgewertet. Hierdurch ist die Lageorientierung auf der Leiterplatte zu erkennen.

Die aufgenommenen Ist-Werte werden sämtlichst mit einer der zu prüfenden Flachbaugruppe 6 entsprechenden Soll-Struktur verglichen. Dies kann zum einen durch die Aufnahme eines Masters, also einer ideal bestückten Flachbaugruppe geschehen, wobei die aufgenommenen Daten und berechneten Kennwerte in einem interaktiven Selbstlernverfahren Schritt für Schritt ermittelt werden. Eine andere Möglichkeit stellt die Sollwertvorgabe in Form einer Sollstruktur dar, die als CAD-Entwurf (computerunterstützte Konstruktion) vorliegt. Ein derartiger Entwurf enthält bereits sämtliche idealen Daten, die eine Flachbaugruppe 6 enthalten soll.

Die projizierte Fläche F kann für die Höhe H mit Z = 0, sowie auch für verschiedene Höhen H der Bauelemente 3 bestimmt werden. Hierdurch sind die Bauelemente 3 in verschiedene parallel zur X/Y-Ebene liegende Flächen scheibchenweise zerlegbar. Dies ergibt den besonderen Vorteil, daß die Oberflächenformen der Bauelemente sehr differenziert erkannt werden können.

Um Durchbiegungen der Leiterplatte 5 oder Fehlmessungen, verursacht durch transparentes Leiterplattenmaterial, auszugleichen und auszuschalten wird eine Untergrundkorrektur der Istwertdaten anhand eines ortsabhängigen Untergrundsignales mit der Referenzhöhe Z = 0 durchgeführt. Hiermit werden die ursprünglich aufgenommenen 3D-Daten derart korrigiert, daß die wahre Höhe zwischen Oberfläche bzw. Deckfläche eines Bauelementes 3 und der Leiterplatte 5 erkannt wird. Zur Durchführung dieser Nettohöhenkontrolle werden verschiedene Referenzpositionen auf der Leiterplatte 5 in der Nähe von zu vermessenden Bauelementen 3 aufgenommen. Zur Durchführung der Normierung wird beispielsweise in Schritten mit 0,1 mm die vorliegende Höhe der Leiterplatte 5 aufgenommen und bei vorhandenen Durchbiegungen der Leiterplatte 5 die Abweichung von der Höhe der Sollstruktur als Untergrundsignal verarbeitet. Damit sind die wahren Höhenwerte der Meßobjekte, in diesem Fall der Bauelemente 3, feststellbar.

Fehlmessungen, die mit Fehlern behaftete Oberflächenkoordinaten X, Y, Z ergeben können außerdem durch Reflektionen oder durch die nicht idealen Eigenschaften der 3D-Sensoren, die sogenanntes Rauschen produzieren, innerhalb der aufgenommenen Daten erscheinen. Derartige Ausreißer werden durch die digitale dreidimensionale Informationsverarbeitung eliminiert. Das Verfahren ist nicht abhängig von der Lichtintensität, die eingebracht bzw. von der Flachbaugruppe reflektiert wird. Damit ist das Verfahren von der Beschaffenheit der Bauteile 3 und deren Oberfläche unabhängig.

Ein weiteres wesentliches Merkmal des Verfahrens ist die Aufnahme eines Höhenhistogramms. Das dreidimensionale Höhenhistogramm ist lage- und drehinvariant und nur von der Neigung der Bauelemente bezüglich der Z-Achse abhängig. Räumliche Orientierung z.B. die Richtung von Anschlußenden auf der Leiterplattenunterseite können damit lageunabhängig überprüft werden. Bei konstantem Neigungswinkel φ erlaubt der Vergleich der Höhenverteilung des zu erkennenden Bauelementes mit gespeicherten Sollstrukturen eine Unterscheidung komplizierter Bauformen mit gleichem Gesamtvolumen V. Dies wird besonders wichtig beim Vergleich von verschiedenen Lötstellen, ist aber auch auf die Kontrolle von Bauelementen 3 anwendbar. Des weiteren trägt die Aufnahme eines Höhenhistogrammes dazu bei, daß Störsignale, deren Anzahl im Verhältnis zur gesamten Zahl der aufgenommenen Daten relativ gering ist, eliminiert werden.

In der Fig. 3 sind beispielhaft für drei verschiedene Lagen desselben Körpers, in diesem Fall eines Zylinders, die zugehörigen Höhenhistogramme dargestellt. Die Fig. 3 a zeigt einen Zylinder, dessen Achse parallel zur Z-Achse verläuft. Damit ist sein Neigungswinkel φ = 0 und seine Oberfläche bzw. seine Deckfläche parallel zur X/Y-Ebene. Das Höhenhistogramm ergibt die Anzahl n der Punkte mit gleicher Höhe H in Abhängigkeit von der Höhe H wieder, wobei dies Koordinatenrichtung Z entspricht. In der Fig. 3a ist deutlich zu sehen, daß sämtliche Punkte auf der Deckfläche des Zylinders die gleiche Höhe haben und durch die senkrecht stehende Zylinderfläche keinerlei Punkte anderer Höhe aufgenommen werden.

Die Fig. 3b zeigt den Zylinder unter einem Neigungswinkel φ = 45° geneigt. Da hier die Darstellung aller Punkte gleicher Höhe durch einen waagerechten, also parallel zur X/Y-Ebene liegenden, Schnitt am besten verdeutlicht wird, ist gleichzeitig erkennbar, daß in diesem Fall bei der senkrechten Betrachtung von oben alle aufgenommenen Oberflächenkoordinaten nicht nur eine Höhe aufweisen können. Daraus erklärt sich der Verlauf des dargestellten Höhenhistogrammes.

Die Fig. 3 c zeigt das Höhenhistogramm für einen liegenden Zylinder. Für diesen Fall ist wiederum zu bemerken, daß die Oberflächenkoordinaten der unteren Hälfte des Zylinders nicht aufgenommen werden. Die Grund- oder Deckflächen entfallen in diesem Fall auch, da sie parallel zur Aufnahmerichtung sind. Damit läßt sich der Verlauf des Höhenhistogrammes leicht erklären, denn die aufgenommenen Oberflächenkoordinaten liegen sämtlichst auf der oberen Hälfte des Halbzylinders. Beginnend bei niedrigen Höhenwerten Z ist die Lage von differenziell kleinen Flächenelementen in Bezug auf die senkrechte Aufnahmerichtung mehr oder weniger parallel. Mit zunehmenden Höhenwerten Z werden diese Flächenelemente zunehmend senkrecht von oben abgetastet. Das erklärt den Kurvenverlauf des Höhenhistogrammes mit einem steten Anstieg bis zu einem Maximum.

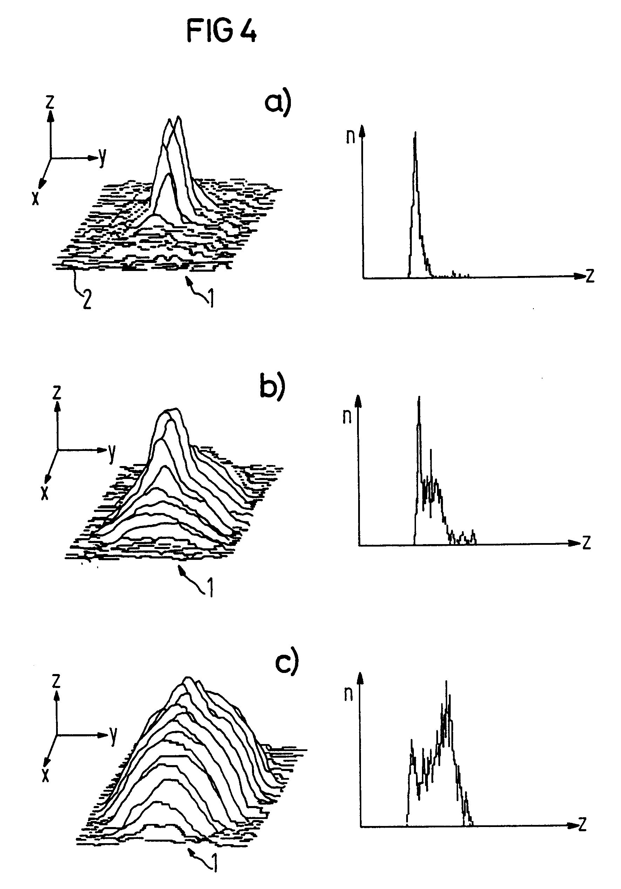

Die Fig. 4 zeigt drei verschiedene Aufnahmen von Lötstellen, wobei links die an den Koordinatenrichtungen X, Y, Z orientierten Höhenrasterprofile von Lötstellen und rechts daneben die zugehörigen Höhenhistogramme dargestellt sind. Hier ist wiederum die Anzahl n der Punkte mit gleicher Höhe über der Höhe aufgetragen, wobei die Höhe in Richtung der Z-Achse verläuft.

Die Fig. 4 a zeigt ein Höhenrasterprofil 1 einer Lötstelle mit zu wenig Lotmaterial. Das Höhenrasterprofil 1 gibt das wahre Bild der Lötstelle in Form von Höhenrasterlinien 2 mit diskreten Höhenstufen wieder. Im zugehörigen Höhenhistogramm ist zu erkennen, daß im unteren Bereich von Z entsprechend dem flächig ausgebreiteten Lotmaterial eine große Anzahl n von Punkten gleicher Höhe vorhanden ist. Eine Mindeststärke der Lotschicht wird jedoch nicht erreicht, da in Richtung höherer Werte von Z nur eine geringe Anzahl n von Oberflächenpunkten überhaupt auftaucht.

In der Fig. 4 b ist eine gute Lotstelle widergegeben. Das Höhenhistogramm weist in diesem Fall für niedrige Z-Werte eine große Anzahl n von Punkten in gleicher Höhe auf, was dem flächigen Verlaufen des Lotmateriales entspricht. Zu höheren Z-Werten ist ein Bauch von Lotmaterial erkennbar, dessen Oberfläche weder waagerecht noch senkrecht verläuft, sondern annähernd ideal gerundet ist. In Richtung noch höherer Z-Werte ist zu erkennen, daß im Gegensatz zum Höhenhistogramm in der Fig. 4 a in diesem Fall das Anschlußbein von Lotmaterial umgeben sein muß, denn eine größere Querschnittsfläche, parallel zur X/Y-Ebene, ist verbunden mit einer größeren Anzahl n von Punkten in gleicher Höhe.

In der Fig. 4 c ist eine Lötstelle mit zuviel Lotmaterial widergegeben. Entsprechend ist im Höhenhistogramm mit zunehmenden Werten von Z keine stetig oder in Stufen abfallende Kurve zu erkennen. Die höchsten Werte der Anzahl n liegen sogar bei relativ hohen Werten von Z, was darauf hinweist, daß die Lotstelle eine kovexe, annähernd kugelförmige Ausbildung besitzt.

Die Abtastung einer Flachbaugruppe 6 durch einen Laserscanner erfolgt bereichs- oder streifenweise, wobei die Flachbaugruppe beispielsweise auf einem X/Y-Tisch mäanderförmig bewegt wird und der Laserscanner ortsfest senkrecht von oben arbeitet. Die mäanderförmige Bewegung der Leiterplatte wird durch die endliche Breite des Meßbereiches des Laserscanners erforderlich. Nachdem die Flachbaugruppe 6 streifenweise geprüft wird, ist es möglich, daß ein Bauelement innerhalb von zwei Streifen mit jeweils einem Prüffenster versehen wird. Für diesen Fall müssen beide Prüffenster beurteilt werden.

Aus der beispielhaften Durchführung des Verfahrens mit den dazu nötigen Geräten ergeben sich folgende technische Daten:
- Abtastfläche:: Der Meßbereich für die Bestückprüfung einer Flachbaugruppe (6) wird lateral durch den maximalen Verfahrweg der Positioniereinheiten (X, Y) festgelegt; typisch ist: 460 mm x 460 mm.
- Abtastgeschwindigkeit:: 200.000 Oberflächenkoordinaten/sec.
- Auflösung:: 0,1 x 0,1 x 0,1 mm = Höhe x Breite x Länge.
- Höhenmeßbereich:: bis 25 mm.
- Prüfgeschwindigkeit:: 10 cm²/sec (bezogen auf eine Baugruppe im Europaformat = 16 sec.)

## Patentansprüche

1. Verfahren zur optischen Prüfung von Flachbaugruppen, insbesondere zur Bestückungsanalyse von mit oberflächenmontierbaren Bauelementen bestückten Leiterplatten, wobei
- mittels eines oder mehrerer 3D-Sensoren und durch Abtasten mittels eines Laser-Scanners die dreidimensionalen Oberflächenkoordinaten (X,Y,Z) der Flachbaugruppe ermittelt werden,
- die globale Erkennung einzelner Bauelemente (3) einer Flachbaugruppe (6) anhand der Bestimmung geometrischer Kennwerte, wie Gesamtvolumen (V), projizierte Fläche (F) und maximale Höhe (H-MAX) des Bauelementes (3) durchgeführt wird,
- eine Bestückungsanalyse anhand eines Soll/Ist-Wertvergleiches zwischen den geometrischen Kennwerten einer der Flachbaugruppe entsprechenden Sollstruktur und denen der zu prüfenden Flachbaugruppe (6) vorgenommen wird,
- die ebene Lageorientierung der einzelnen Bauelemente (3) auf der Flachbaugruppe (6) durch Bestimmung ihrer maximalen Länge (L-MAX) und ihrer maximalen Breite (B-MAX) ermittelt wird.

2. Verfahren nach Anspruch 1,
**dadurch gekennzeichnet,**
daß die geometrischen Kennwerte für den Soll/Ist-Wertvergleich mit vorgegebenen Toleranzgrenzen versehen werden.

3. Verfahren nach einem der vorhergehenden Ansprüche,
**dadurch gekennzeichnet,** daß die Neigung eines Bauelementes (3) bezüglich der Flachbaugruppe (6) durch Aufnahme eines Höhenhistogrammes ermittelt wird.

4. Verfahren nach einem der vorhergehenden Ansprüche,
**dadurch gekennzeichnet,**
daß zur Oberflächenkontrolle eines Bauelementes (3) die projizierte Fläche (F) an verschiedenen Höhen (H) des Bauelementes (3) ermittelt wird.

5. Verfahren nach einem der vorhergehenden Ansprüche,
**dadurch gekennzeichnet,**
daß mittels einer oder mehrerer Referenzstellen in der Nähe eines zu prüfenden Bauelementes (3) eine Nettohöhenkontrolle durchgeführt wird.

6. Verfahren nach einem der vorhergehenden Ansprüche,
**dadurch gekennzeichnet,**
daß mehrere Prüffenster orientiert an den zu prüfenden Bauelementen auf der Flachbaugruppe aufgebaut werden.

## Claims

1. Process for the optical testing of flat assemblies, especially for the analysis of the population of printed circuit boards populated with surface-mounted components, in which
- the three dimensional surface co-ordinates (X,Y,Z) of the printed circuit board assembly are determined by means of one or more 3D sensors and by scanning by means of a laser scanner,
- the global recognition of individual components (3) of a printed circuit board assembly (6) is carried out by means of the determination of geometric characteristic values, such as total volume (V), projected surface area (F) and maximum height (H-MAX) of the component (3),
- an analysis of the equipment is undertaken by means of a theoretical/actual value comparison between the geometric characteristic values of a theoretical structure corresponding to the printed circuit board assembly and those of the printed circuit board assembly (6) to be tested, and
- the planar positional orientation of the individual components (3) on the printed circuit board assembly (6) is determined by determination of their maximum length (L-MAX) and their maximum width (B-MAX).

2. Process according to Claim 1, characterized in that the geometric characteristic values for the theoretical/actual value comparison are provided with predetermined tolerance limits.

3. Process according to one of the preceding claims, characterized in that the inclination of a component (3) with respect to the printed circuit board assembly (6) is determined by recording a height histogram.

4. Process according to one of the preceding claims, characterized in that for the surface monitoring of a component (3) the projected surface area (F) at various heights (H) of the component (3) is determined.

5. Process according to one of the preceding claims, characterized in that a nett height monitoring is carried out by means of one or more reference positions in the vicinity of a component (3) to be tested.

6. Process according to one of the preceding claims, characterized in that a plurality of test windows are constructed, oriented with respect to the components to be tested on the printed circuit board assembly.

## Revendications

1. Procédé de contrôle optique de modules plats, notamment pour l'analyse de l'équipement de plaquettes à circuits imprimés équipées de composants pouvant être montés en surface, selon lequel
- les coordonnées tridimensionnelles de surface (X,Y,Z) du module plat sont déterminées au moyen d'un ou de plusieurs capteurs tridimensionnels et par exploration à l'aide d'un scanner laser,
- l'identification globale des divers composants (3) d'un module plat (6) est effectuée en déterminant des valeurs caractéristiques géométriques, tel que le volume total (V), la surface projetée (F) et la hauteur maximale (H-MAX) du composant (3),
- une analyse de l'équipement est effectuée au moyen d'une comparaison valeur de consigne/valeur réelle entre les valeurs caractéristiques géométriques d'une structure de consigne correspondant au module plat et celles du module plat (6) contrôler,
- l'orientation de position des divers composants (3) sur le module plat (6) dans un plan est obtenue en déterminant leur longueur maximale (L-MAX) et leur largeur maximale (B-MAX).

2. Procédé suivant la revendication 1, caractérisé par le fait que les valeurs caractéristiques géométriques pour la comparaison valeur de consigne/valeur réelle sont affectées de limites prescrites de tolérance.

3. Procédé suivant l'une des revendications précédentes, caractérisé par le fait que l'inclinaison d'un composant (3) par rapport au module plat (6) est déterminée par l'enregistrement d'un histogramme de hauteur.

4. Procédé suivant l'une des revendications précédentes, caractérisé par le fait que pour le contrôle de la surface d'un composant (3), la surface projetée (F) est déterminée à différentes hauteurs (H) du composant.

5. Procédé suivant l'une des revendications précédentes, caractérisé par le fait qu'un contrôle de hauteur nette est effectué au moyen d'un ou de plusieurs points de référence à proximité d'un composant à contrôler (3).

6. Procédé suivant l'une des revendications précédentes, caractérisé par le fait que plusieurs fenêtres de contrôle sont formées en étant orientées sur les composants à contrôler sur le module plat.
